# FASCICULE DE BREVET EUROPEEN

(11) **EP 2 440 690 B1**
(45) Date de publication et mention de la délivrance du brevet: **16.07.2014**
(21) Numéro de dépôt: 10724020.2
(22) Date de dépôt: 26.05.2010
(51) Int. Cl.: C25D 1/00, B81C 99/00, C25D 5/02, G03F 7/00

(54) **PROCEDE DE FABRICATION D'UNE MICROSTRUCTURE METALLIQUE**
VERFAHREN ZUR HERSTELLUNG EINER METALL-MIKROSTRUKTUR
METHOD FOR MANUFACTURING A METAL MICROSTRUCTURE

(30) Priorité: 12.06.2009 EP 09162638
(43) Date de publication de la demande: 18.04.2012
(73) Titulaire: Nivarox-FAR S.A., 2400 Le Locle (CH)
(72) Inventeur: FUSSINGER, Alexandre, CH-2075 Wavre (CH)
(74) Mandataire: Couillard, Yann Luc Raymond
(86) Numéro de dépôt international: PCT/EP2010/057255
(87) Numéro de publication internationale: WO 2010/142529

(56) Documents cités:
- EP-A- 0 607 680
- EP-A- 1 835 339
- JP-A- 9 279 366
- CHARLES BECNEL ET AL: "Ultra-deep x-ray lithography of densely packed SU-8 features: I. An SU-8 casting procedure to obtain uniform solvent content with accompanying experimental results; Ultra-deep x-ray lithography of densely packed SU-8 features" JOURNAL OF MICROMECHANICS & MICROENGINEERING, INSTITUTE OF PHYSICS PUBLISHING, BRISTOL, GB, vol. 15, no. 6, 1 juin 2005 (2005-06-01), pages 1242-1248, XP020091587 ISSN: 0960-1317
- DENTINGER P M ET AL: "High aspect ratio patterning with a proximity ultraviolet source" MICROELECTRONIC ENGINEERING, ELSEVIER PUBLISHERS BV., AMSTERDAM, NL, vol. 61-62, 1 juillet 2002 (2002-07-01), pages 1001-1007, XP004360644 ISSN: 0167-9317

## Description

### Domaine de l'invention

La présente invention concerne un procédé de fabrication d'une microstructure métallique par une technologie de type LIGA. En particulier l'invention concerne un tel procédé pour la fabrication d'une telle microstructure ayant des caractéristiques dimensionnelles plus précises et mieux contrôlées que les procédés de l'art antérieur. L'invention concerne également un telle pièce métallique obtenue par ce procédé.

### Arrière-plan de l'invention

La technologie LIGA (Lithographie Galvanik Abformung) développée par W. Ehrfeld du Karlsruhe Nuclear Research Center, Allemagne, dans les années 80 s'est révélée intéressante pour la fabrication de microstructures métalliques de hautes précisions.

Dans son principe la technique LIGA consiste à déposer sur un substrat conducteur ou revêtu d'une couche conductrice, une couche d'une résine photosensible, à effectuer, à travers un masque correspondant au contour de la microstructure désirée, une irradiation X au moyen d'un synchrotron; à développer, c'est-à-dire à éliminer par des moyens physiques ou chimiques les portions de la couche de résine photosensible non irradiées afin de définir un moule ayant le contour de la microstructure, à déposer galvaniquement un métal typiquement du nickel dans le moule en résine photosensible puis à éliminer le moule pour libérer la microstructure.

La qualité des microstructures obtenues ne prête pas à critique, mais la nécessité de mettre en oeuvre un équipement coûteux (synchrotron) rend cette technique peu compatible avec une production de masse de microstructures devant avoir un faible coût unitaire.

C'est pourquoi sur la base de ce procédé LIGA ont été développées des procédé analogues mais utilisant des résines photosensibles aux UV. Un tel procédé est, par exemple, décrit dans la publication de A.B. Frazier et al., intitulée « Metallic Microstructures Fabricated Using Photosensitive Polyimide Electroplating Molds", Journal of Microelectromechanical systems, Vol. 2, N deg. 2, June 1993 pour la fabrication de structures métalliques par électrodéposition de métal dans des moules en résine photosensible à base de polyimide. Ce procédé comprend les étapes suivantes :
- créer sur substrat une couche métallique sacrificielle et une couche d'amorçage pour une étape ultérieure d'électrodéposition ;
- appliquer une couche de résine polyimide photosensible ;
- irradier à l'UV la couche de résine polyimide à travers un masque correspondant au contour de la microstructure désirée ;
- développer en dissolvant les parties non irradiées de la couche de polyimide de façon à obtenir une pluralité de moules en polyimide ;
- déposer galvaniquement du nickel dans les parties ouvertes des moules jusqu'à la hauteur de ces derniers ;
- séparer les structures métalliques obtenues du substrat ; et
- éliminer les moules en polyimide pour libérer les pièces métalliques électroformées.

Les pièces ou microstructures électroformées sont donc obtenues en vrac. Une fois obtenues, ces pièces sont séparées et doivent être recollées sur une plaque afin de les usiner et/ou rectifier pour les amener à l'épaisseur et à l'état de surface désirés.

Le document EP 1 835 339 propose, entre l'étape de dépôt galvanique et l'étape de séparation, de réaliser des usinages de finition tel qu'un chanfreinage quand les pièces métalliques sont encore sur le substrat.

Ces étapes requièrent des temps de manipulation élevés et comportent des risques important de disposer les pièces à l'envers sur ladite plaque notamment lorsque les pièces électroformées sont de faibles dimensions, typiquement des pièces de dimensions inférieures au millimètre. Ces procédés induisent un taux de rebut et donc des coûts de revient non compatibles avec les exigences d'un procédé industriel.

Par ailleurs les procédés de l'art antérieur nécessitent un dépôt de matière électroformée suffisamment important pour garantir que toutes les pièces atteignent leur épaisseur minimum indépendamment des variations d'épaisseur de la résine à la surface du substrat. Ceci entraîne donc une consommation de matière électrodéposée inutile.

En effet, les variations d'épaisseurs de la résine déposée pour former les moules sont intrinsèques aux techniques de dépôts actuelles, typiquement la tournette ou le spray coating. On notera à ce propos que la non uniformité de la couche de résine dans laquelle les moules sont formés nécessite d'irradier la résine avec un réglage prenant en compte le maximum et le minimum de l'épaisseur. Cela a pour conséquence d'augmenter la dispersion des dimensions géométriques dans le plan des moules.

II existe donc un besoin pour un procédé permettant de s'affranchir de ces inconvénients.

### Résumé de l'invention

La présente invention a pour but de remédier aux inconvénients susmentionnés ainsi qu'à d'autres encore en fournissant un procédé permettant de fabriquer des pièces ou microstructures ayant des épaisseurs et des états de surfaces mieux contrôlés et plus précis que les pièces ou microstructures obtenues par les procédés de l'art antérieur.

L'invention a également pour but un tel procédé permettant une réduction des coûts de l'électroformage tant du point de vue du temps de fabrication que de la quantité de matière électrodéposée.

L'invention a également pour but d'améliorer l'uniformité de l'exposition photolithographique et donc l'amélioration de l'uniformité géométrique des pièces produites sur la surface d'un même substrat.

La présente invention a également pour but de fournir un tel procédé qui soit simple et peu coûteux à mettre en oeuvre.

A cet effet, l'invention dans ces trois variantes comportent les étapes communes ayant pour objet un procédé de fabrication d'une pluralité de pièces ou microstructures métalliques caractérisé en ce qu'il comprend les étapes consistant à :
a) se munir d'un substrat conducteur ou d'un substrat isolant recouvert d'une couche conductrice d'amorçage ;
b) appliquer sur la partie conductrice de la surface du substrat une couche de résine photosensible ;
c) aplanir la surface de la couche de résine photosensible jusqu'à une épaisseur et/ou un état de surface désiré ;
d) irradier la couche de résine à travers un masque définissant le contour de la microstructure désirée ;
e) dissoudre les zones non polymérisées de la couche de résine photosensible pour faire apparaître par endroit la surface conductrice du substrat ou le substrat si ce dernier est conducteur ;
f) déposer galvaniquement au moins une couche d'un métal à partir de ladite couche conductrice pour former des blocs atteignant sensiblement la surface supérieure de la résine photosensible ;
h) séparer la couche de résine et les pièces électroformées du substrat.

Ce procédé permet donc de réaliser une couche de résine d'une épaisseur déterminée et constante sur toute la surface du substrat. Cela permet donc d'exposer une couche de résine présentant une épaisseur uniforme ce qui permet la réalisation de moules puis de pièces terminées présentant une précision dimensionnelles uniforme dans le plan pour les pièces d'un même substrat.

Typiquement, le procédé de l'invention permet de garantir une précision de +/- 2 µm sur l'épaisseur de la résine déposée, alors que les procédés de l'art antérieur sont limités à une précision de l'ordre +/- 30 µm (dépôt à la tournette).

Par ailleurs, l'aplanissement de la résine avant l'étape d'électroformage des pièces permet, d'une part, de limiter la quantité de métal à déposer pour obtenir plus tôt des ponts entre les pièces comme cela sera expliqué ci-après (gain de temps) et, d'autre part, d'obtenir une galette, c'est-à-dire un ensemble de pièces électroformées reliées entre elles par des ponts de matière, beaucoup plus régulière en épaisseur du côté supérieur pour garantir un collage plus régulier sur la plaque de travail pour des opérations d'usinage ultérieurs.

Dans le cas d'un procédé LIGA multi-niveaux, l'aplanissement de la résine permet d'obtenir une tolérance serrée sur l'épaisseur des différents niveaux sur toute l'étendue du substrat, donc sur toutes les pièces du substrat.

Selon une caractéristique de l'invention, l'étape d'aplanissement c) est réalisée à l'aide d'un outil de coupe et de préférence à l'aide d'un outil comportant une portion coupante en métal dur, en céramique, en carbure métallique, en nitrure métallique ou en diamant.

L'utilisation d'un tel outil pour réaliser l'étape d'aplanissement permet d'éviter toute contamination de la résine et/ou du métal électroformé par des résidus qui résulterait des procédés de meulage ou de polissage. De plus, l'usinage à l'aide d'un outil de coupe n'est pas sensible aux différences d'épaisseur de la matière à usiner (résine ou résine et pièces électroformées ou pièces collées sur une plaque de travail).

Selon une première variante avantageuse de l'invention, durant l'étape f) le métal est déposé au-delà de la hauteur du moule pour s'étendre sur la surface aplanie de la résine et ainsi relier les pièces entre elles par des ponts métalliques pour former une galette, et après l'étape h), les pièces métalliques reliées entre elles par lesdits ponts sont soumises aux étapes suivantes de:
j) fixation sur une plaque de travail par leur face de référence opposée aux ponts ;
k) usinage de leurs faces exposées pour les mettre à l'épaisseur et/ou à l'état de surface désiré tout en éliminant les ponts, libérant ainsi lesdites pièces les unes des autres ;
l) libération desdites pièces terminées de la plaque de travail.

Selon cette première variante de réalisation, les ponts métalliques entre les pièces permettent :
1. le transfert des pièces sur la plaque de travail pour la mise en épaisseur ;
2. de garantir un pressage régulier sur la plaque de travail au moment de la fixation des pièces sur celle-ci ce qui permet de réduire la dispersion de la cote d'épaisseur finie ;
3. de garantir l'arrangement précis et régulier des pièces pour une opération subséquente d'usinage additionnel (électroérosion, usinage par enlèvement de copeaux, diamantage, polissage, décors, etc.).

Autrement dit, on réalise une surcroissance de métal lors de la déposition LIGA pour créer des ponts entre toutes les pièces et pouvoir ainsi manipuler la galette qui conserve la localisation très régulière et précise des pièces obtenues par le procédé LIGA. Cette galette peut être ensuite solidarisée à une plaque de travail. La reprise mécanique des pièces peut ainsi se faire sur une machine CNC en bénéficiant du positionnement précis des pièces (des repères peuvent être électroformés directement sur la galette).

Le procédé de l'invention permettant avantageusement de conserver l'arrangement précis et régulier des pièces après enlèvement des ponts de matière électroformée pour réaliser des pièces multiniveaux par usinage, réaliser des décors, réaliser des revêtements (sélectifs ou complets), réaliser des chanfreins ou lamages, assemblage en batch, etc. au moyen de machines à commande numérique, de robots, pour une production industrielle.

Selon une deuxième variante de réalisation, après l'étape de séparation h), les pièces électroformées ne sont plus reliées entre elles, ces pièces sont soumises aux étapes suivantes de :
m)application d'une bande de transfert sur la face opposée à la face de référence desdites pièces ;
n) fixation sur une plaque de travail par leur face de référence opposée à la bande ;
o) usinage de leurs faces exposées pour les mettre à l'épaisseur et/ou à l'état de surface désiré ;
p) libérer lesdites pièces terminées de la plaque de travail.

Selon une troisième variante de réalisation, dans lequel après l'étape de séparation h) les pièces électroformées ne sont pas reliées entre elles par des ponts métalliques, mais par la résine. Ces pièces sont soumises aux étapes suivantes de :
q) fixation sur une plaque de travail par leur face de référence ;
r) usinage de leurs faces exposées pour les mettre à l'épaisseur et/ou à l'état de surface désiré ;
s) libération desdites pièces terminées de la plaque de travail.

Selon une caractéristique avantageuse de l'invention, avant l'étape I) p) s), les pièces encore fixées sur la plaque de travail sont soumises à une étape d'usinage dans l'épaisseur des pièces.

Les étapes k) o) r) décrites ci-dessus peuvent bien entendu être réalisée par des outils de coupe.

Le procédé de l'invention trouve une application particulièrement avantageuse pour la fabrication de pièces micromécaniques de mouvements d'horlogerie ou d'outillage. En particulier, les pièces pourront être choisies parmi l'ensemble constitué des roues dentées, des roues d'échappement, des ancres, des pièces pivotées, des ressorts sautoir, des ressorts spiral et des pièces passives, des cames, des poussoirs, des viroles, des moules, des broches, des tasseaux, d'électrodes pour l'électroérosion.

### Description sommaire des dessins

D'autres caractéristiques et avantages de la présente invention ressortiront plus clairement de la description détaillée qui suit d'un exemple de réalisation d'un procédé selon l'invention, cet exemple étant donné à titre purement illustratif et non limitatif seulement, en liaison avec le dessin annexé sur lequel :
- les figures 1a à 1h illustrent les étapes de procédé d'un premier mode de réalisation de l'invention en vue de la réalisation d'une pluralité de roues dentées ;
- les figures 2a à 2k illustrent une première variante de réalisation de l'invention ;
- les figures 3a à 3k illustrent une deuxième variante de réalisation de l'invention ;
- les figures 4a à 4j illustrent une troisième variante de réalisation de l'invention.

### Description détaillée des modes de réalisation préférés

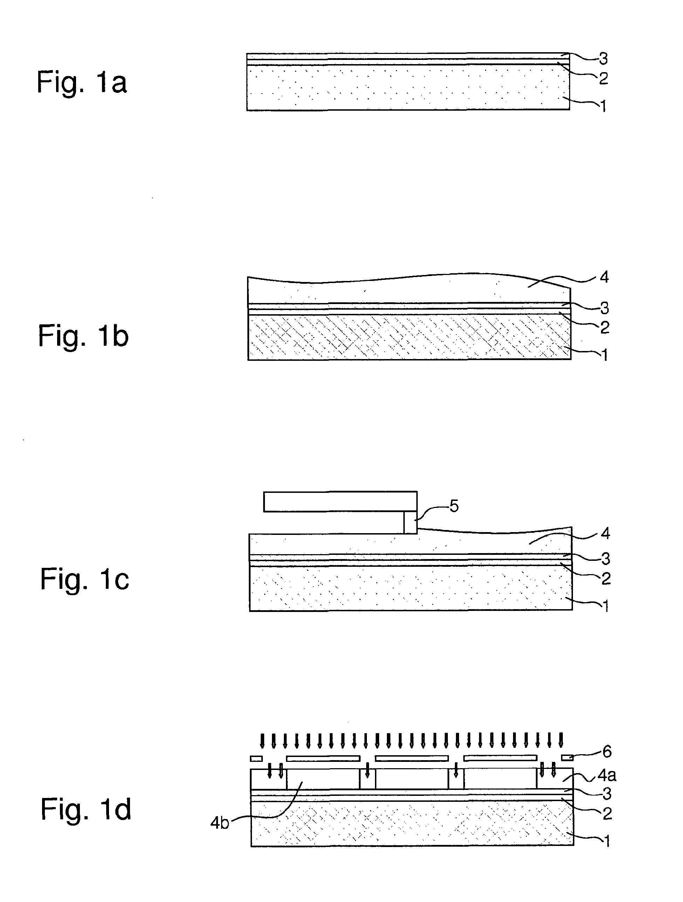

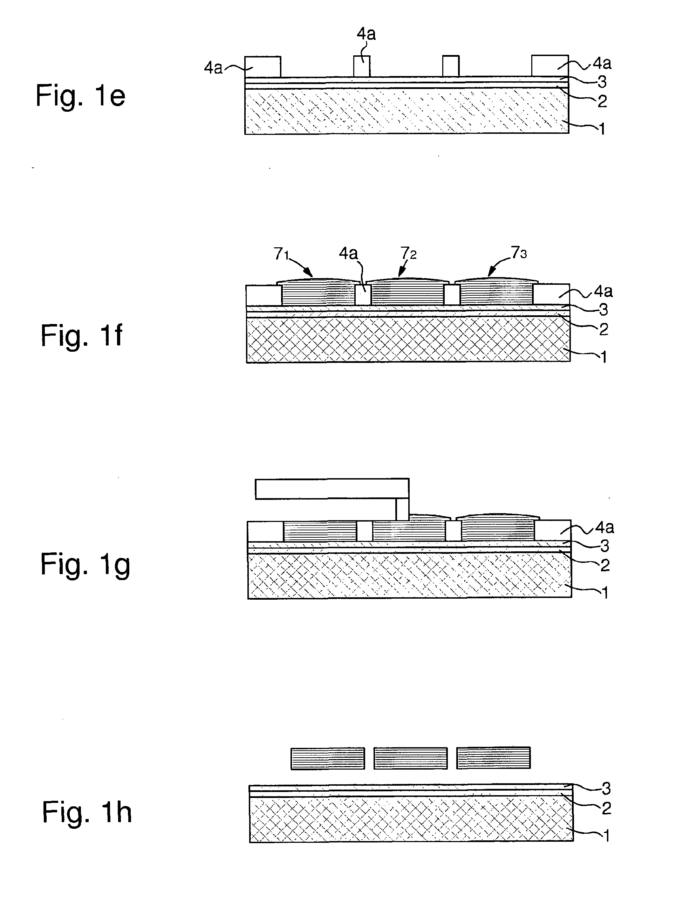

En se référant aux figures 1 a à 1 h on va décrire un premier mode de réalisation de l'invention.

Le substrat 1 utilisé dans l'étape a) du procédé selon l'invention est, par exemple, formé par une plaquette de silicium, de verre ou de céramique sur laquelle on a déposé par évaporation, une couche d'amorçage, c'est-à-dire une couche apte à démarrer une réaction d'électroformage. Typiquement, la couche d'amorçage est formée d'une sous-couche de chrome 2 et d'une couche d'or 3 (figure 1a).

Alternativement, le substrat peut être réalisé en acier inoxydable ou en un autre métal apte à démarrer une réaction d'électroformage. Dans ce cas, la couche d'amorçage 2, 3 n'est plus nécessaire. Dans le cas d'un substrat en acier inoxydable, ce dernier sera dégraissé avant usage.

La résine photosensible 4 utilisée à l'étape b) du procédé selon l'invention est de préférence une résine à base d'époxy octofonctionnelle disponible chez Shell Chemical sous la référence SU-8 et d'un photoinitiateur choisi parmi les sels de triarylsulfonium tels que ceux décrits dans le brevet US 4,058,401. Cette résine est susceptible d'être polymérisée sous l'action d'un rayonnement UV. On notera qu'un solvant qui s'est révélé approprié pour cette résine est la gammabutyrolactone (GBL) (figure 1 b).

Alternativement, une résine à base de phénolformaldéhydique de type Novolac en présence d'un photoinitiateur DNQ (DiazoNaphtoQuinone) peut également être utilisée.

La résine 4 est déposée sur le substrat 1 par tout moyen approprié typiquement à la tournette jusqu'à l'épaisseur souhaitée. Typiquement, l'épaisseur de résine est comprise entre 150 µm et 1 mm. Selon l'épaisseur désirée et la technique de dépôt utilisée, la résine 4 sera déposée en une ou plusieurs fois. Alternativement, la résine 4 peut être déposée par la technique de spray coating.

La résine 4 est ensuite chauffée entre 80 et 95° C pendant une durée dépendant de l'épaisseur déposée pour évacuer le solvant. Ce chauffage sèche et durcit la résine.

A l'étape c), le substrat est monté sur le porte pièce d'une machine outil sur laquelle on procède à l'aplanissement de la surface de la couche de résine photosensible durcie jusqu'à une épaisseur et/ou un état de surface désiré (figure 1 c). Cette opération d'aplanissement est réalisée au moyen d'un outil de coupe 5 de manière à éviter toute contamination de la résine par des résidus que pourrait provoquer un aplanissement par un outil d'abrasion classique. On notera que cette opération d'aplanissement est réalisée de préférence à sec, c'est-à-dire sans aucune lubrification afin d'éviter toute pollution chimique de la résine.

Typiquement, l'outil de coupe est un outil comportant une portion coupante en métal dur, en céramique, en carbure métallique, en nitrure métallique ou en diamant. A l'issue de cette étape, on obtient un substrat revêtu d'une couche de résine 4 dont la surface est parfaitement plane et parallèle au substrat. La résine présente en outre un état de surface ayant une valeur de Ra < 25 nm et une épaisseur désirée avec une tolérance de ± 2µm.

L'état de surface obtenu ainsi que la précision géométrique de l'épaisseur de la résine sont particulièrement intéressants dans le cas d'un procédé multi-niveaux car cet état de surface détermine l'état de surface du dépôt galvanique crû à partir de cette surface et l'épaisseur maîtrisée permet de garantir les cotes de chaque niveau de chaque pièce.

L'étape d) suivante illustrée à la figure 1d consiste à irradier la couche de résine aplanie au moyen d'un rayonnement UV à travers un masque 6 définissant le contour des microstructures désirées et ainsi des zones insolées 4a et des zones non insolées 4b. Typiquement, cette irradiation UV est de 200 à 1'000 mJ.cm⁻², mesurée à une longueur d'onde de 365 nm selon l'épaisseur de la couche.

Le cas échéant, une étape de recuit de la couche peut être nécessaire pour compléter la photopolymérisation induite par l'irradiation UV. Cette étape de recuit est effectuée de préférence entre 90°C et 95°C pendant 15 à 30 mn. Les zones insolées (photopolymérisées) deviennent insensibles à une grande majorité de solvants. Par contre, les zones non insolées pourront ultérieurement être dissoutes par un solvant.

L'étape e) suivante illustrée à la figure 1e consiste à développer les zones non insolées 4b de la couche de résine photosensible pour faire apparaître par endroit la couche conductrice 3 du substrat 1. Cette opération est réalisée par dissolution des zones non insolées 4b au moyen d'un solvant choisi parmi la GBL (gammabutyrolactone) et le PGMEA (propylène glycol méthyle éthyle acétate). Une pluralité de moules en résine photosensible insolée 4a présentant les contours des structures métalliques sont ainsi réalisés.

L'étape f) suivante illustrée à la figure 1 consiste à déposer galvaniquement dans les moules une couche d'un métal à partir de ladite couche conductrice 3 jusqu'à former une pluralité de blocs 7₁, 7₂, 7₃ atteignant et dépassant la hauteur des moules. Par métal dans ce contexte sont bien entendu compris les alliages métalliques. Typiquement, le métal sera choisi parmi l'ensemble comprenant le nickel, le cuivre, l'or ou l'argent, et, comme alliage, l'or-cuivre, le nickel-cobalt, le nickel-fer, le nickel-phosphore ou le nickel-tungstène.

Les conditions d'électroformage, notamment la composition des bains, la géométrie du système, les tensions et densités de courant, sont choisis pour chaque métal ou alliage à électrodéposer selon les techniques bien connues dans l'art de l'électroformage (cf. par exemple Di Bari G.A. "electroforming" Electroplating Engineering Handbook 4th Edition rédigée par L.J. Durney, publié par Van Nostrand Reinhold Compagny Inc., N.Y. USA 1984).

Dans une étape g) subséquente illustrée à la figure 1g, on procède à la mise à niveau du bloc électroformé avec la couche de résine. Cette étape peut se faire par abrasion et polissage ou usinage par un outil de coupe afin d'obtenir directement des microstructures ayant une surface supérieure plane présentant notamment un état de surface compatible avec les exigences de l'industrie horlogère pour la réalisation de mouvement de haut de gamme.

L'étape h) suivante illustrée à la figure 1h consiste à séparer la couche de résine 4a et le bloc électrodéposé 7₁, 7₂, 7₃ du substrat 1. Une fois cette opération de délaminage effectuée, on élimine la couche de résine photosensible 4a de la structure délaminée pour libérer les microstructures 7₁, 7₂, 7₃ ainsi formées. Pour ce faire, on élimine dans une étape finale la résine par une attaque plasma.

La microstructure ainsi libérée peut être utilisée soit directement soit, le cas échéant, après un usinage approprié.

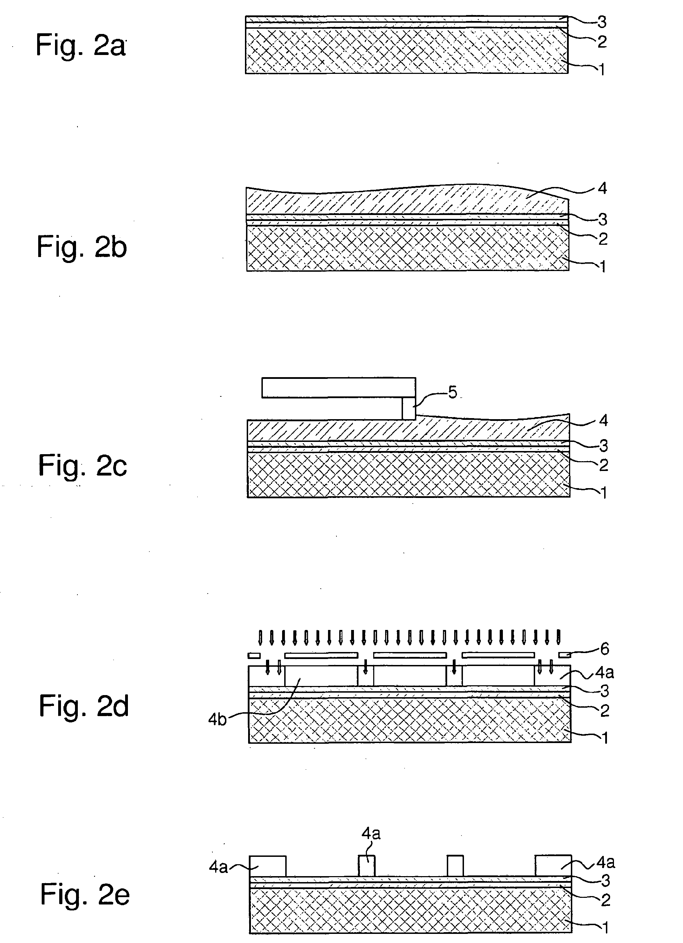

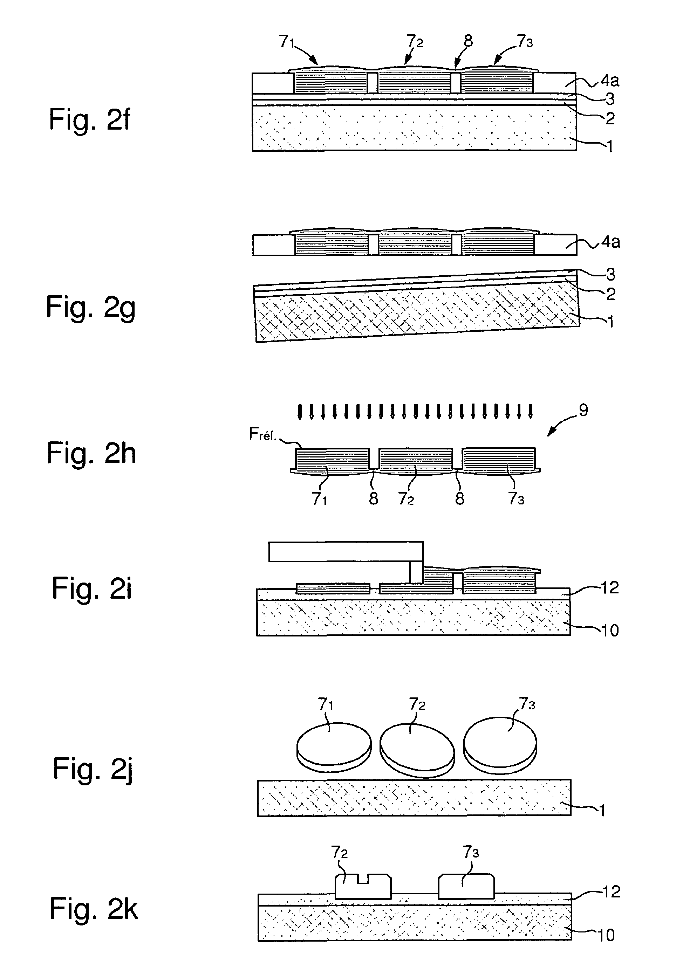

On va maintenant décrire une première variante de l'invention en liaison avec les figures 2a à 2k. Dans cette première variante, les étapes illustrée aux figures 2a à 2e sont identiques à celles décrites et illustrées aux figures 1 a à 1 e. Dans cette première variante, au cours de l'étape f) le dépôt galvanique dans les moules est réalisé jusqu'à former une pluralité de blocs 7₁, 7₂, 7₃ atteignant et dépassant la hauteur des moules de manière à s'étendre sur la surface supérieure de la résine photosensible 4a et former des ponts métalliques 8 pour relier les différents blocs 7₁, 7₂, et 7₃ entre eux (figure 2f). L'étape g) est éliminée.

On sépare ensuite le substrat 1 de l'ensemble résine 4a et blocs 7₁, 7₂, 7₃ électroformés au cours d'une étape de délaminage (figure 2g). La résine 4a est alors éliminée pour libérer les blocs 7₁, 7₂, 7₃ reliés entre eux par les ponts 8 formant une galette 9. Typiquement, l'élimination de la résine 4a est réalisée par une attaque plasma (figure 2h). La galette 9 est ensuite fixée typiquement par collage (colle 12) sur une plaque de travail 10 par sa face de référence F_{réf}. opposée aux ponts, c'est-à-dire la face qui était en contact avec le substrat 1 (figure 2i). Les faces exposées sont usinées pour mettre les blocs 7₁, 7₂, et 7₃ à l'épaisseur et/ou à l'état de surface désiré tout en éliminant les ponts 8 et former des pièces finies ou semi finies. Au cours de cette étape, lesdits blocs 7₁, 7₂, et 7₃ sont libérés les uns des autres tout en étant encore maintenus en position précise et définie dans la colle 12 (figure 2i).

A l'issue de cette étape, lesdites pièces obtenues peuvent être soit libérées de la plaque de travail 10 puis nettoyées (figure 2j), soit reprises sur une machine outil pour opérer des usinages en lot (figure 2k). A ce stade, les pièces peuvent être soumises à divers traitements décoratifs et/ou fonctionnels, typiquement des dépôts physiques ou chimiques.

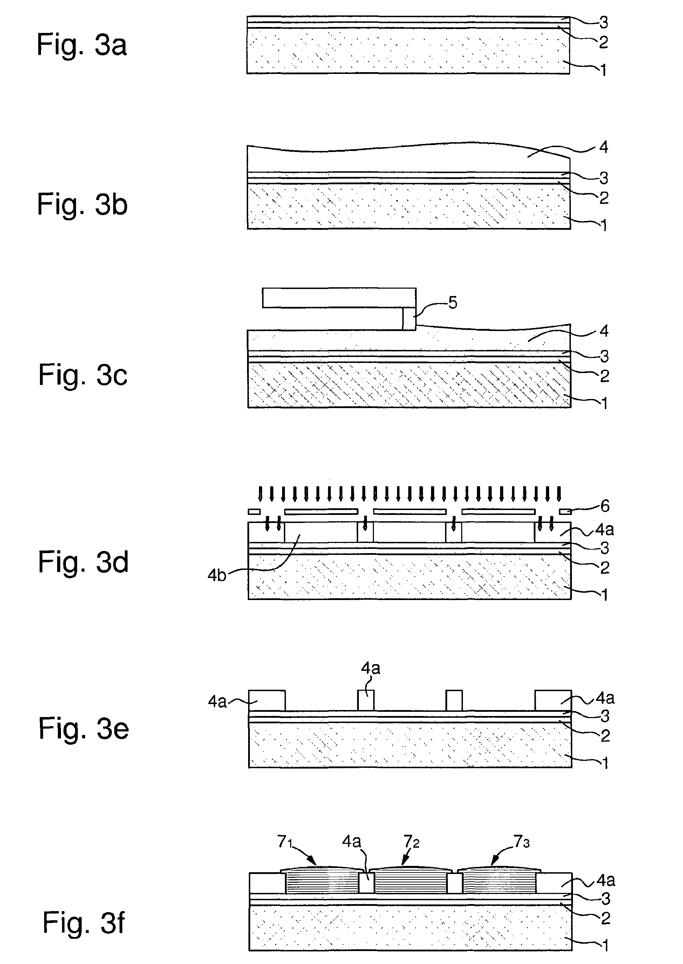

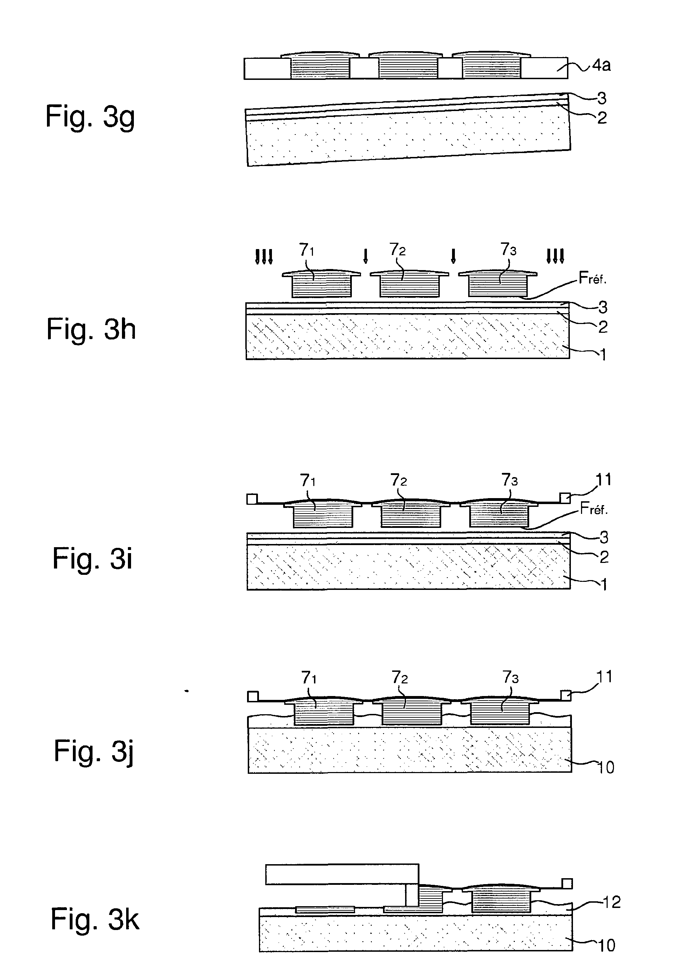

On va maintenant décrire une deuxième variante de l'invention en liaison avec les figures 3a à 3k. Dans cette deuxième variante, les étapes illustrée aux figures 3a à 3f sont identiques à celles décrites et illustrées aux figures 1a à 1 f. Dans cette deuxième variante l'étape g) est également éliminée et après l'étape f), on sépare le substrat 1 de l'ensemble résine 4a et blocs électroformés 7₁, 7₂ et 7₃ au cours d'une étape de délaminage (figure 3g). La résine 4a est alors éliminée pour libérer les blocs 7₁, 7₂ et 7₃. Typiquement, l'élimination de la résine est réalisée par une attaque plasma (figure 3h). Les blocs électroformées 7₁, 7₂, 7₃ ne sont plus reliés entre eux.

On applique ensuite une bande de transfert tendue sur un cadre 11 sur la face opposée à la face de référence F_{réf}. desdits blocs c'est-à-dire la face qui était en contact avec le substrat 1 (figure 3i). Les blocs 7₁, 7₂, 7₃ collés sur la bande de transfert sont ensuite fixés typiquement par collage sur une plaque de travail 10 par leur face de référence, c'est-à-dire la face qui était en contact avec le substrat 1 (figure 3j). Le cadre est retiré en laissant la bande de transfert.

Les faces exposées des blocs sont ensuite usinées pour former les pièces 7₁, 7₂ et 7₃ à l'épaisseur et/ou à l'état de surface désiré tout en éliminant la bande transfert. Au cours de cette étape, lesdits pièces sont libérées les unes des autres de la bande de transfert tout en étant maintenues dans la colle 12 (figure 3k). A l'issue de cette étape, lesdites pièces sont libérées de la plaque de travail 10 puis nettoyées.

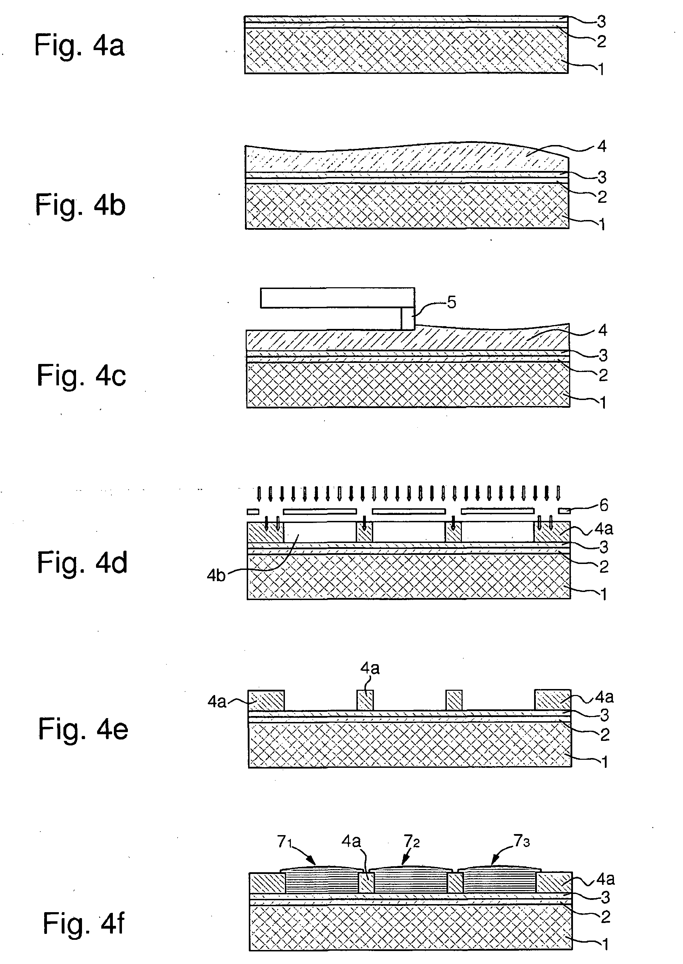

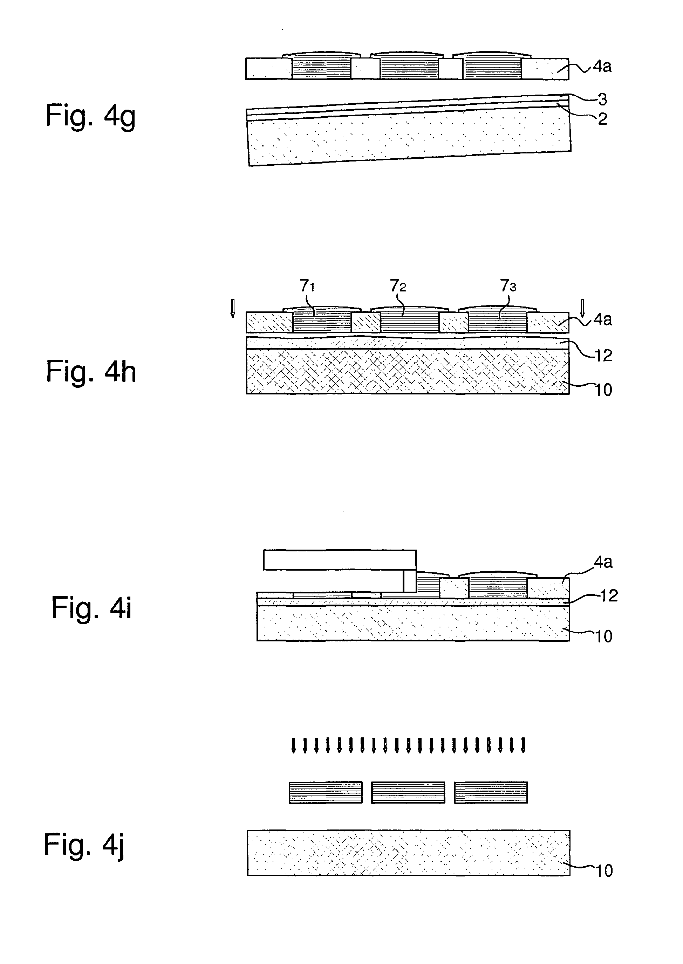

On va maintenant décrire une troisième variante de l'invention en liaison avec les figures 4a à 4j. Dans cette troisième variante, les étapes illustrée aux figures 4a à 4f sont identiques à celles décrites et illustrées aux figures 1a à 1 f. Dans cette troisième variante, l'étape g) est également éliminée. Cette variante s'applique dans le cas où l'adhérence de l'ensemble résine - blocs électroformés n'est pas suffisante pour permettre un usinage direct des blocs 7₁, 7₂, 7₃ sur le substrat 1. Dans ce cas, on sépare le substrat 1 de l'ensemble résine 4a et blocs électroformés 7₁, 7₂ et 7₃ au cours d'une étape de délaminage (figure 4g).

On procède ensuite au collage de l'ensemble résine - blocs électroformés sur une plaque de travail 10 par leur face de référence, c'est-à-dire la face qui était en contact avec le substrat 1 (figure 4h). Les faces exposées des blocs 7₁, 7₂, 7₃ sont ensuite usinées pour former les pièces à l'épaisseur et/ou à l'état de surface désiré. Les pièces sont maintenues par la résine 4a et par la colle 12 (figure 4i).

A l'issue de cette étape, lesdites pièces sont libérées de la plaque de travail 10 puis la résine 4a est alors éliminée pour libérer les pièces obtenues. Typiquement, l'élimination de la résine est réalisée par une attaque plasma (figure 4j). Selon l'invention, on notera encore qu'avant l'étape illustrée respectivement aux figures 1e, 2e, 3e, et 4e les étapes illustrées et décrites en liaison respectivement avec les figures 1b à 1d, 2b à 2d, 3b à 3d et 4b à 4d sont répétées au moins une fois pour obtenir des pièces multi-niveaux.

Le nombre de niveaux n'est donc pas limité. Pour des applications horlogères, le nombre typique de niveaux est de 1 à 5.

Dans le cas de la réalisation de moules en résine multi-niveaux, il est avantageux de déposer sur la résine après l'étape 1 d, 2d, 3d, 4d une couche conductrice permettant une croissance régulière de la matière électrodéposée au cours de l'étape ultérieure 1f, 2f, 3f, 4f.

## Revendications

1. procédé de fabrication d'une pluralité de microstructures métalliques **caractérisé en ce qu'**il comprend les étapes consistant à :
a) se munir d'un substrat (1) conducteur ou d'un substrat (1) isolant recouvert d'une couche (3) conductrice d'amorçage ;
b) appliquer sur la partie conductrice (3) de la surface du substrat (1) une couche (4) de résine photosensible ;
c) aplanir la surface de la couche (4) de résine photosensible jusqu'à une épaisseur et/ou un état de surface désiré ;
d) irradier la couche de résine (4) à travers un masque (6) définissant le contour de la microstructure désirée ;
e) dissoudre les zones (4b) non polymérisées de la couche (4) de résine photosensible pour faire apparaître par endroit la surface (3) conductrice du substrat (1) ;
f) déposer galvaniquement au moins une couche d'un métal à partir de ladite couche conductrice pour former une pluralité de blocs (71, 72, 73), le métal étant déposé au-delà de la hauteur du moule (4a) pour s'étendre sur la surface aplanie de la résine (4a) de manière à relier les blocs (71, 72, 73) par des ponts (8) métalliques, lesdits ponts étant situés sur la face opposée aux faces de référence (F_{réf.}) ;
h) séparer la couche (4a) de résine et les blocs reliés (71, 72, 73) du substrat (1) ;
i) éliminer la couche (4a) de résine photosensible des blocs reliés (71, 72, 73) ;
j) ensuite fixer sur une plaque (10) de travail les blocs reliés (71, 72, 73) par leur face de référence (F_{réf.}) ;
k) usiner leurs faces exposées pour les mettre à l'épaisseur et/ou à l'état de surface désiré tout en éliminant les ponts (8) pour libérer les blocs (71, 72, 73) les uns des autres ;
l) libérer de la plaque (10) de travail les pièces ou microstructure ainsi formées.

2. procédé de fabrication d'une pluralité de microstructures métalliques **caractérisé en ce qu'**il comprend les étapes consistant à :
a) se munir d'un substrat (1) conducteur ou d'un substrat (1) isolant recouvert d'une couche (3) conductrice d'amorçage ;
b) appliquer sur la partie conductrice (3) de la surface du substrat (1) une couche (4) de résine photosensible ;
c) aplanir la surface de la couche (4) de résine photosensible jusqu'à une épaisseur et/ou un état de surface désiré ;
d) irradier la couche de résine (4) à travers un masque (6) définissant le contour de la microstructure désirée ;
e) dissoudre les zones (4b) non polymérisées de la couche (4) de résine photosensible pour faire apparaître par endroit la surface (3) conductrice du substrat (1) ;
f) déposer galvaniquement au moins une couche d'un métal à partir de ladite couche conductrice pour former une pluralité de blocs (71, 72, 73) atteignant sensiblement la surface supérieure de la résine (4a) photosensible ;
h) séparer la couche (4a) de résine et les blocs (71, 72, 73) du substrat (1) ;
i) éliminer de la couche (4a) de résine photosensible des blocs (71, 72, 73) ;
m)appliquer une bande (11) de transfert sur la face opposée à la face de référence (F_{réf.}) desdits blocs (71, 72, 73), soit sur la face opposée à la face qui était en contact avec le substrat (1) ;
n) fixer sur une plaque (10) de travail, par leur face de référence (F_{réf.}), les blocs (71, 72, 73) reliés par la bande (11) de transfert ;
o) usiner leurs faces exposées pour les mettre à l'épaisseur et/ou à l'état de surface désiré tout en éliminant la bande de transfert (11) pour libérer les blocs (71, 72, 73) les uns des autres ;
p) libérer de la plaque (10) de travail les pièces ou microstructure ainsi formées.

3. procédé de fabrication d'une pluralité de microstructures métalliques **caractérisé en ce qu'**il comprend les étapes consistant à :
a) se munir d'un substrat (1) conducteur ou d'un substrat (1) isolant recouvert d'une couche (3) conductrice d'amorçage ;
b) appliquer sur la partie conductrice (3) de la surface du substrat (1) une couche (4) de résine photosensible ;
c) aplanir la surface de la couche (4) de résine photosensible jusqu'à une épaisseur et/ou un état de surface désiré ;
d) irradier la couche de résine (4) à travers un masque (6) définissant le contour de la microstructure désirée ;
e) dissoudre les zones (4b) non polymérisées de la couche (4) de résine photosensible pour faire apparaître par endroit la surface (3) conductrice du substrat (1) ;
f) déposer galvaniquement au moins une couche d'un métal à partir de ladite couche conductrice pour former une pluralité de blocs (71, 72, 73) atteignant sensiblement la surface supérieure de la résine (4a) photosensible ;
h) séparer la couche (4a) de résine et les blocs (71, 72, 73) du substrat (1) ;
q) fixer sur une plaque (10) de travail la couche (4a) de résine et les blocs (71, 72, 73) par leur face de référence (F_{réf.}), soit par la face qui était en contact avec le substrat (1) ;
r) usiner leurs faces exposées pour les mettre à l'épaisseur et/ou à l'état de surface désiré ;
s) libérer de la plaque (10) de travail et de la couche (4a) de résine, les pièces ou microstructure ainsi formées.

4. Procédé selon l'une des revendications 1 à 3, **caractérisé en ce que** l'étape d'aplanissement c) est réalisée à l'aide d'un outil de coupe.

5. Procédé selon la revendication 4, **caractérisé en ce que** l'outil de coupe est un outil comportant une portion coupante en métal dur, céramique, carbure métallique, nitrure métallique ou en diamant.

6. Procédé selon l'une des revendications précédentes, **caractérisé en ce que**, avant l'étape finale de libération, les pièces ou microstructure encore fixées sur la plaque (10) de travail sont soumises à une étape d'usinage dans l'épaisseur des pièces.

7. Procédé selon l'une des revendications précédentes, **caractérisé en ce que**, avant l'étape finale de libération, les pièces ou microstructure encore fixées sur la plaque (10) de travail sont soumises à une étape de dépôt physique ou chimique.

8. Procédé selon l'une des revendications précédentes, **caractérisé en ce que**, avant l'étape e), les étapes b), c) et d) sont répétées au moins une fois pour obtenir des pièces multi-niveaux.

## Patentansprüche

1. Verfahren zum Herstellen einer Vielzahl von metallischen Mikrostrukturen, **dadurch gekennzeichnet, dass** es folgende Schritte umfasst:
a) Bereitstellen eines leitenden Substrats (1) oder eines isolierenden Substrats (1), das mit einer leitenden Überschlagschicht (3) bedeckt ist;
b) Aufbringen einer Schicht (4) aus strahlungsempfindlichem Harz auf den leitenden Teil (3) der Oberfläche des Substrats (1);
c) Abgleichen der Oberfläche der Schicht (4) aus strahlungsempfindlichem Harz bis zu einer gewünschten Dicke und/oder Oberflächenbeschaffenheit;
d) Bestrahlen der Harzschicht (4) durch eine Maske (6) hindurch, die den Umriss der gewünschten Mikrostruktur definiert;
e) Auflösen der nichtpolymerisierten Zonen (4b) der Schicht (4) aus strahlungsempfindlichem Harz, um stellenweise die leitende Oberfläche (3) des Substrats (1) erscheinen zu lassen;
f) galvanisches Niederschlagen wenigstens einer Schicht aus einem Metall ausgehend von der leitenden Schicht, um eine Vielzahl von Blöcken (7₁, 7₂, 7₃) zu bilden, wobei das Metall über die Höhe der Form (4a) hinaus aufgebracht wird, um sich auf der flachgemachten Oberfläche des Harzes (4a) derart zu erstrecken, dass es die Blöcke (7₁, 7₂, 7₃) durch metallische Brücken (8) miteinander verbindet, wobei diese Brücken auf der den Referenzflächen (F_{ref.}) entgegengesetzten Seite liegen;
h) Trennen der Harzschicht (4a) und der miteinander verbundenen Blöcke (7₁, 7₂, 7₃) vom Substrat (1);
i) Entfernen der Schicht (4a) aus strahlungsempfindlichem Harz von den miteinander verbundenen Blöcken (7₁, 7₂, 7₃);
j) Befestigen der miteinander verbundenen Blöcke (7₁, 7₂, 7₃) über ihre Referenzfläche (F_{réf.}) an einer Arbeitsplatte (10);
k) Bearbeiten ihrer exponierten Flächen, um ihnen die gewünschte Dicke und/oder Oberflächenbeschaffenheit zu verleihen, wobei die Brücken (8) entfernt werden, um die Blöcke (7₁, 7₂, 7₃) voneinander freizumachen;
l) Befreien der so gebildeten Stücke oder Mikrostruktur von der Arbeitsplatte (10).

2. Verfahren zum Herstellen einer Vielzahl von metallischen Mikrostrukturen, **dadurch gekennzeichnet, dass** es folgende Schritte umfasst:
a) Bereitstellen eines leitenden Substrats (1) oder eines isolierenden Substrats (1), das mit einer leitenden Überschlagschicht (3) bedeckt ist;
b) Aufbringen einer Schicht (4) aus strahlungsempfindlichem Harz auf den leitenden Teil (3) der Oberfläche des Substrats (1);
c) Abgleichen der Oberfläche der Schicht (4) aus strahlungsempfindlichem Harz bis zu einer gewünschten Dicke und/oder Oberflächenbeschaffenheit;
d) Bestrahlen der Harzschicht (4) durch eine Maske (6) hindurch, die den Umriss der gewünschten Mikrostruktur definiert;
e) Auflösen der nichtpolymerisierten Zonen (4b) der Schicht (4) aus strahlungsempfindlichem Harz, um stellenweise die leitende Oberfläche (3) des Substrats (1) erscheinen zu lassen;
f) galvanisches Niederschlagen wenigstens einer Schicht aus einem Metall ausgehend von der leitenden Schicht, um eine Vielzahl von Blöcken (7₁, 7₂, 7₃) zu bilden, die merklich die obere Fläche des strahlungsempfindlichen Harzes (4a) erreichen;
h) Trennen der Harzschicht (4a) und der Blöcke (7₁, 7₂, 7₃) vom Substrat (1);
i) Entfernen der Schicht (4a) aus strahlungsempfindlichem Harz von den Blöcken (7₁, 7₂, 7₃);
m) Anbringen eines Übergangsbandes (11) auf der der Referenzfläche (F_{réf.}) der Blöcke (7₁, 7₂, 7₃) entgegengesetzten Seite, also auf der Seite, die der Fläche, welche mit dem Substrat (1) in Kontakt war, entgegengesetzt ist;
n) Befestigen der durch das Übergangsband (11) miteinander verbundenen Blöcke (7₁, 7₂, 7₃) über ihre Referenzfläche (F_{réf.}) an einer Arbeitsplatte (10);
o) Bearbeiten ihrer exponierten Flächen, um ihnen die gewünschte Dicke und/oder Oberflächenbeschaffenheit zu verleihen, wobei das Übergangsband (11) entfernt wird, um die Blöcke (7₁, 7₂, 7₃) voneinander freizumachen;
p) Befreien der so gebildeten Stücke oder Mikrostruktur von der Arbeitsplatte (10).

3. Verfahren zum Herstellen einer Vielzahl von metallischen Mikrostrukturen, **dadurch gekennzeichnet, dass** es folgende Schritte umfasst:
a) Bereitstellen eines leitenden Substrats (1) oder eines isolierenden Substrats (1), das mit einer leitenden Überschlagschicht (3) bedeckt ist;
b) Aufbringen einer Schicht (4) aus strahlungsempfindlichem Harz auf den leitenden Teil (3) der Oberfläche des Substrats (1);
c) Abgleichen der Oberfläche der Schicht (4) aus strahlungsempfindlichem Harz bis zu einer gewünschten Dicke und/oder Oberflächenbeschaffenheit;
d) Bestrahlen der Harzschicht (4) durch eine Maske (6) hindurch, die den Umriss der gewünschten Mikrostruktur definiert;
e) Auflösen der nichtpolymerisierten Zonen (4b) der Schicht (4) aus strahlungsempfindlichem Harz, um stellenweise die leitende Oberfläche (3) des Substrats (1) erscheinen zu lassen;
f) galvanisches Niederschlagen wenigstens einer Schicht aus einem Metall ausgehend von der leitenden Schicht, um eine Vielzahl von Blöcken (7₁, 7₂, 7₃) zu bilden, die merklich die obere Fläche des strahlungsempfindlichen Harzes (4a) erreichen;
h) Trennen der Harzschicht (4a) und der Blöcke (7₁, 7₂, 7₃) vom Substrat (1);
q) Befestigen der Harzschicht (4a) und der Blöcke (7₁, 7₂, 7₃) über ihre Referenzfläche (F_{réf.}), d.h. über die Fläche, die mit dem Substrat (1) in Kontakt war, an der Arbeitsplatte (10);
r) Bearbeiten ihrer exponierten Flächen, um ihnen die gewünschte Dicke und/oder Oberflächenbeschaffenheit zu verleihen;
s) Befreien der so gebildeten Stücke oder Mikrostruktur von der Arbeitsplatte (10) und von der Harzschicht (4a).

4. Verfahren nach einem der Ansprüche 1 bis 3, **dadurch gekennzeichnet, dass** der Abgleichungsschritt c) mit Hilfe eines Schneidwerkzeugs ausgeführt wird.

5. Verfahren nach Anspruch 4, **dadurch gekennzeichnet, dass** das Schneidwerkzeug ein Werkzeug ist, das einen schneidenden Abschnitt aus Hartmetall, Keramik, Karbid, Metall-Nitrid oder aus Diamant umfasst.

6. Verfahren nach einem der vorhergehenden Ansprüche, **dadurch gekennzeichnet, dass** die Stücke oder Mikrostruktur, die noch an der Arbeitsplatte (10) befestigt sind, vor dem abschliessenden Befreiungsschritt einem Schritt zum Bearbeiten der Dicke der Stücke unterworfen werden.

7. Verfahren nach einem der vorhergehenden Ansprüche, **dadurch gekennzeichnet, dass** die Stücke oder Mikrostruktur, die noch an der Arbeitsplatte (10) befestigt sind, vor dem abschliessenden Befreiungsschritt einem physikalischen oder chemischen Niederschlagschritt unterworfen werden.

8. Verfahren nach einem der vorhergehenden Ansprüche, **dadurch gekennzeichnet, dass** die Schritte b), c) und d) wenigstens einmal vor dem Schritt e) wiederholt werden, um Mehrebenen-Stücke zu erhalten.

## Claims

1. Method of fabricating a plurality of metallic microstructures, **characterized in that** it includes the steps consisting in:
a) taking a conductive substrate (1) or an insulating substrate (1) coated with a conductive seed layer (3);
b) applying a layer (4) of photosensitive resin over the conductive part (3) of the substrate surface (1);
c) flattening the surface of the photosensitive resin layer (4) to the desired thickness and/or surface state;
d) irradiating the resin layer (4) through a mask (6) defining the contour of the desired microstructure;
e) dissolving the non-polymerized areas (4b) of the photosensitive resin layer (4) to reveal, in places, the conductive surface (3) of the substrate (1);
f) depositing at least one layer of a metal from said conductive layer to form a plurality of blocks (71, 72, 73), metal being deposited beyond the height of the mould (4a) to extend over the flattened surface of the resin, so as to connect the blocks (71, 72, 73) to each other by metallic bridges (8), said bridges being located on the opposite face to said reference faces (F_{réf.});
h) separating the resin layer (4a) and the connected blocks (71, 72, 73) from the substrate (1);
i) removing the photosensitive resin layer (4a) from the connected blocks (71, 72, 73);
j) then fixing the connected blocks (71, 72, 73) to a work plate (10) by the reference face (F_{réf.}) thereof;
k) machining the exposed faces to give said faces the desired thickness and/or surface state, removing the bridges (8), and thereby releasing said blocks (71, 72, 73) from each other;
l) releasing from the plate (10) the parts or microstructures thereby formed.

2. Method of fabricating a plurality of metallic microstructures, **characterized in that** it includes the steps consisting in:
a) taking a conductive substrate (1) or an insulating substrate (1) coated with a conductive seed layer (3);
b) applying a layer (4) of photosensitive resin over the conductive part (3) of the substrate surface (1);
c) flattening the surface of the photosensitive resin layer (4) to the desired thickness and/or surface state;
d) irradiating the resin layer (4) through a mask (6) defining the contour of the desired microstructure;
e) dissolving the non-polymerized areas (4b) of the photosensitive resin layer (4) to reveal, in places, the conductive surface (3) of the substrate (1);
f) depositing at least one layer of a metal from said conductive layer to form a plurality of blocks (71, 72, 73) substantially reaching the upper surface of the photosensitive resin (4a);
h) separating the resin layer (4a) and the blocks (71, 72, 73) from the substrate (1);
i) removing the photosensitive resin layer (4a) from the blocks (71, 72, 73);
m)applying a transfer strip (11) to the opposite face to the reference face (F_{réf.}) of said blocks (71, 72, 73), that was on the opposite face of the face that was in touch with the substrate (1);
n) fixing the blocks (71, 72, 73) connected by the transfer strip (11) to a work plate (10) by the reference face (F_{réf.}) thereof;
o) machining the exposed faces to give said faces the desired thickness and/or surface state, removing the transfer strip (11), and thereby releasing said blocks (71, 72, 73) from each other;
p) releasing from the plate (10) the parts or microstructures thereby formed.

3. Method of fabricating a plurality of metallic microstructures, **characterized in that** it includes the steps consisting in:
a) taking a conductive substrate (1) or an insulating substrate (1) coated with a conductive seed layer (3);
b) applying a layer of photosensitive resin (4) over the conductive part (3) of the substrate surface (1);
c) flattening the surface of the photosensitive resin layer (4) to the desired thickness and/or surface state;
d) irradiating the resin layer (4) through a mask (6) defining the contour of the desired microstructure;
e) dissolving the non-polymerized areas (4b) of the photosensitive resin layer (4) to reveal, in places, the conductive surface (3) of the substrate (1);
f) depositing at least one layer of a metal on said conductive layer to form a plurality of blocks (71, 72, 73) substantially reaching the upper surface of the photosensitive resin (4a);
h) separating the resin layer (4a) and the blocks (71, 72, 73) from the substrate (1);
q) fixing the separated resin layer (4a) and blocks (71, 72, 73) to a work plate (10) by the reference face (F_{réf.}) that was in touch with the substrate (1);
r) machining the exposed faces to give said faces the desired thickness and/or surface state;
s) releasing, from the working plate (10) and from the resin layer (4a), the parts or microstructure thereby formed.

4. Method according to any of claims 1 to 3, **characterized in that** the flattening step c) is performed using a cutting tool.

5. Method according to claim 4, **characterized in that** the cutting tool is a tool including a cutting edge portion made of hard metal, ceramic, metal carbide, metallic nitride or diamond.

6. Method according to any of preceding claims, **characterized in that**, before the last releasing step, the parts or microstructure still fixed onto the working plate (10) are subjected to a machining step in the thickness of parts.

7. Method according to any of preceding claims, **characterized in that**, before the last releasing step, the parts or microstructure still fixed onto the working plate (10) are subjected to a physical or chemical deposition step.

8. Method according to any of preceding claims, **characterized in that**, before the step e), the steps b), c) and d) are repeated at least once to obtain multi-level parts.
